# EUROPÄISCHE PATENTSCHRIFT

(11) **EP 4 365 446 B1**
(45) Veröffentlichungstag und Bekanntmachung des Hinweises auf die Patenterteilung: **23.07.2025**
(21) Anmeldenummer: 23199258.7
(22) Anmeldetag: 25.09.2023
(51) Int. Cl.: F03H 1/00, G01R 19/175, H03K 5/1536, H05H 1/46, H03L 7/00

(54) **REGELUNGSVORRICHTUNG FÜR EIN IONENTRIEBWERK, IONENTRIEBWERKE MIT REGELUNGSVORRICHTUNG UND PLASMAENERGETISCHE SCHUTZEINRICHTUNG**
CONTROL DEVICE FOR AN ION ENGINE, ION ENGINES WITH CONTROL DEVICE AND PLASMA-ENERGY PROTECTION DEVICE
DISPOSITIF DE RÉGULATION POUR UN MOTEUR IONIQUE, MOTEURS IONIQUES AVEC UN DISPOSITIF DE RÉGULATION ET UN DISPOSITIF DE PROTECTION À PLASMA ÉNERGÉTIQUE

(30) Priorität: 12.10.2022 DE 102022126571
(43) Veröffentlichungstag der Anmeldung: 08.05.2024
(73) Patentinhaber: Tesat Spacecom GmbH & Co. KG, 71522 Backnang (DE)
(72) Erfinder: LAMPE, Alexander, 71522 Backnang (DE); ARTMANN, Jochen, 71522 Backnang (DE)
(74) Vertreter: LKGLOBAL Lorenz & Kopf Patentanwalt Attorney at Law PartG mbB

(56) Entgegenhaltungen:
- DE-A1- 102017 107 177
- US-A- 4 622 478

## Beschreibung

### Technisches Gebiet

Die vorliegende Beschreibung betrifft eine Regelungsvorrichtung für einen Frequenzgenerator, insbesondere für einen Frequenzgenerator für ein Ionentriebwerk, sowie ein Ionentriebwerk. Das Ionentriebwerk enthält eine solche Regelungsvorrichtung. In weiteren Ausgestaltungen enthält das Ionentriebwerk zusätzlich eine oder mehrere plasmaenergetische Schutzeinrichtungen, die einen Leistungsüberschlag auf Leistungsversorgungskomponenten des Ionentriebwerks verhindern oder eingrenzen.

### Technischer Hintergrund

Ionentriebwerke werden typischerweise als Antrieb für Raumfahrzeuge oder Satelliten genutzt. Ein Ionenstrahl wird erzeugt und treibt das Raumfahrzeug nach dem Rückstoßprinzip an. Der Ionenstrahl wird erzeugt, indem Teilchen ionisiert und anschließend in einem elektrischen Feld beschleunigt werden.

Bei dem sogenannten Radiofrequenz-Ionentriebwerk werden die Ionen mittels induktiver Einkopplung eines Hochfrequenzsignals erzeugt. Um dieses Hochfrequenzsignal zu erzeugen, wird üblicherweise ein Schwingkreis bzw. Frequenzgenerator genutzt.

DE 10 2017 107 177 A1, deren Inhalt auch unter EP 3 386 275 A1 und US 2018 / 0 283 365 A1 veröffentlicht wurde, beschreibt den allgemeinen Aufbau eines Ionentriebwerks mit einem Frequenzgenerator und einer dem Frequenzgenerator zugeordneten Regelungsvorrichtung, welche das Abgeben von elektrischer Energie durch den Frequenzgenerator an eine Triebwerkseinheit des Ionentriebwerks regelt. Die Regelungsvorrichtung enthält eine Erfassungseinheit und eine Recheneinheit. Die Erfassungseinheit erfasst den Stromverlauf und den Spannungsverlauf der von dem Frequenzgenerator abgegebenen elektrischen Energie und liefert Informationen, die den Stromverlauf und den Spannungsverlauf charakterisieren, an die Recheneinheit. Die Recheneinheit ist ausgestaltet, den Spannungsverlauf der von dem Frequenzgenerator abgegebenen elektrischen Energie zu variieren, damit das Ionentriebwerk bei der Resonanzfrequenz betrieben wird.

US 4 622 478 A beschreibt ein Signalübertragungssystem, welches die Gebäude- oder Hausverkabelung als Datenübertragungsleitung nutzt. Ein Frequenzerfassungssystem wird verwendet, um die Frequenz der Netzspannung zu erfassen. Das Frequenzerfassungssystem umfasst einen Nulldurchgangs-Erfassungsschaltkreis zur Entwicklung eines Erfassungsausgangs, wenn der Nulldurchgang erfasst wird. Das Frequenzerfassungssystem verfügt über ein Zeitgeberelement, das dazu dient, ein Ausgangssignal des Nulldurchgangs-Erfassungsschaltkreises für einen vorgewählten Zeitraum zu vernachlässigen, nachdem der letzte Erfassungsausgang vom Nulldurchgangs-Erfassungsschaltkreis entwickelt wurde.

### Beschreibung

Es kann als Aufgabe betrachtet werden, einen Wirkungsgrad beim Betreiben einer Last mit elektrischer Energie in Form von Wechselstrom und Wechselspannung zu verbessern und den Einfluss von Störungen auf die Übertragung von elektrischer Energie in Form von Wechselstrom und Wechselspannung an eine Last zu minimieren.

Diese Aufgabe wird gelöst durch den Gegenstand des Anspruchs 1. Weitere Ausführungsformen ergeben sich aus den abhängigen Ansprüchen sowie aus der folgenden Beschreibung.

Gemäß der Erfindung ist eine Regelungsvorrichtung für einen Frequenzgenerator angegeben. Die Regelungsvorrichtung weist eine Erfassungseinheit und eine Recheneinheit auf. Die Erfassungseinheit ist ausgeführt, einen Spannungsverlauf und einen Stromverlauf des einen Frequenzgenerators zu erfassen und an die Recheneinheit zu übertragen. Die Recheneinheit ist ausgeführt, einen zeitlichen Versatz (Δt₁, Δt₂) zwischen einer Flanke des Stromverlaufs und einer zugehörigen Flanke des Spannungsverlaufs zu ermitteln. Die Recheneinheit ist ausgeführt, ein Schaltsignal zum Ausgeben des Spannungsverlaufs zu erzeugen und zu verändern, um den zeitlichen Versatz zwischen einer Flanke des Stromverlaufs und einer zugehörigen Flanke des Spannungsverlaufs zu reduzieren. Die Erfassungseinheit ist ausgeführt, einen Zeitpunkt eines Nulldurchgangs des Spannungsverlaufs und einen Zeitpunkt eines Nulldurchgangs des Stromverlaufs zu erkennen. Die Erfassungseinheit ist ausgeführt, nach dem Erkennen eines Nulldurchgangs des Spannungsverlaufs und/ oder eines Nulldurchgangs des Stromverlaufs, das erneute Erkennen eines Nulldurchgangs des Spannungsverlaufs und/oder eines Nulldurchgangs des Stromverlaufs für eine Sperrzeit auszusetzen und das erneute Erkennen eines Nulldurchgangs des Spannungsverlaufs und/oder eines Nulldurchgangs des Stromverlaufs erst nach Ablauf der Sperrzeit zuzulassen. Die Erfassungseinheit ist ausgeführt, das erneute Erkennen eines Nulldurchgangs des Spannungsverlaufs und/ oder eines Nulldurchgangs des Stromverlaufs nach Ablauf der Sperrzeit für die Dauer einer Erfassungszeit zuzulassen. Die Erfassungszeit schließt sich unmittelbar an die Sperrzeit an, und hat eine Dauer, die dem Doppelten der Differenz zwischen der aktuellen Periodendauer des Spannungsverlaufs und/oder des Stromverlaufs und dem Anteil der Sperrzeit an dieser aktuellen Periodendauer entspricht.

Die Regelungsvorrichtung erkennt sowohl den Spannungsverlauf als auch den Stromverlauf und detektiert die jeweiligen Nulldurchgänge der erkannten Signalverläufe. Aus zwei aufeinanderfolgenden Nulldurchgängen des Stromverlaufs wird die Phase und Periodendauer des Stromverlaufs abgeleitet.

Aus zwei aufeinanderfolgenden Nulldurchgängen des Spannungsverlaufs wird die Phase und Periodendauer des Spannungsverlaufs abgeleitet. Damit kann auch der zeitliche Versatz zwischen Stromverlauf und Spannungsverlauf ermittelt werden.

Wenn im Folgenden Bezug genommen wird auf die Eigenschaft von "Strom- und/oder Spannungsverlauf" oder eine ähnliche Formulierung verwendet wird, bedeutet das, dass die genannte Eigenschaft sowohl des Stromverlaufs als auch des Spannungsverlaufs betroffen ist.

Die hier beschriebene Regelungsvorrichtung wird dafür verwendet, einen Frequenzgenerator anzusteuern, welcher eine Last mit Energie, insbesondere elektrischer Energie, versorgt. Der Frequenzgenerator gibt Wechselstrom und Wechselspannung bei variierenden und/oder anpassbaren Frequenzen und Phasen an die Last aus. Der Spannungsverlauf wird insbesondere von Frequenz und Phasenlage der Spannung definiert. Der Stromverlauf wird insbesondere von Frequenz und Phasenlage des Stroms definiert. Es ist angestrebt, die Energie mit einem möglichst hohen Wirkungsgrad an die Last zu übergeben. Dies wird erreicht, indem das System bei der Resonanzfrequenz betrieben wird, also dass Stromverlauf und Spannungsverlauf in Phase und ohne zeitlichen Versatz zueinander sind.

Der Frequenzgenerator gibt elektrische Energie in Form von Wechselstrom und Wechselspannung an die Last aus. Der Stromverlauf wird in der Regel von der Last bestimmt bzw. beeinflusst und variiert in Abhängigkeit der Gegebenheiten an oder in der Last. Um die Energie bei der Resonanzfrequenz abzugeben, wird der Spannungsverlauf angepasst.

Um den Verlauf der ausgegebenen Spannung anzupassen, wird üblicherweise ein Schaltwerk verwendet, welches mit bestimmten Schaltsignalen angesteuert wird und basierend auf diesen Schaltsignalen eine Spannung mit einem entsprechenden Spannungsverlauf ausgibt. Das Schaltwerk kann mit Wechselspannung oder Gleichspannung gespeist werden und gibt den gewünschten Spannungsverlauf aus. Für einen solchen AC/AC-Wandler oder DC/AC-Wandler können bekannte Techniken verwendet werden.

Eine steigende Flanke des Stromverlaufs wird einer steigenden Flanke des Spannungsverlaufs zugeordnet und eine fallende Flanke des Stromverlaufs wird einer fallenden Flanke des Spannungsverlaufs zugeordnet. Die Recheneinheit mag den zeitlichen Versatz jeweils zwischen einer ansteigenden Flanke des Stromverlaufs und einer zugeordneten ansteigenden Flanke des Spannungsverlauf und/oder jeweils zwischen einer fallenden Flanke des Stromverlaufs und einer zugeordneten fallenden Flanke des Spannungsverlaufs erfassen. Ein zeitlicher Versatz zwischen den einander zugeordneten Flanken (steigend/steigend und/oder fallend/fallend) weist darauf hin, dass der Frequenzgenerator außerhalb der Resonanzfrequenz betrieben wird.

Die Recheneinheit der Regelungsvorrichtung implementiert einen Algorithmus, der Schaltsignale ermittelt und ausgibt, damit der Frequenzgenerator so geregelt wird, dass er bei der Resonanzfrequenz betrieben wird. Typischerweise werden die Schaltsignale verwendet, um ein Schaltwerk anzusteuern, welches die Spannung schaltet. In anderen Worten wird beispielsweise der Verlauf der Spannung an den Verlauf des Stroms angeglichen.

Die Recheneinheit arbeitet mit den von der Erfassungseinheit erkannten und bereitgestellten Werten. Die Erfassungseinheit erfasst den Verlauf der Spannung und des Stroms an einer Last, an welche der Frequenzgenerator gekoppelt ist und welche der Frequenzgenerator mit Leistung versorgt. Insbesondere erfasst die Erfassungseinheit die Zeitpunkte der Nulldurchgänge des Spannungs- und Stromverlaufs an der Last bzw. am Ausgang des Frequenzgenerators. Diese Zeitpunkte der Nulldurchgänge von Spannungs- und Stromverlauf überträgt die Erfassungseinheit an die Recheneinheit. Basierend auf den Zeitpunkten der Nulldurchgänge von Spannungs- und Stromverlauf ermittelt die Recheneinheit den zeitlichen Versatz zwischen Spannungs- und Stromverlauf. Der zeitliche Versatz zwischen Spannungs- und Stromverlauf kann positiv oder negativ sein, je nachdem, ob der kapazitive Anteil oder der induktive Anteil an der Blindleistung der Last überwiegt. Der ermittelte zeitliche Versatz dient als Grundlage dafür, das Schaltverhalten für das Bereitstellen des Spannungsverlaufs anzupassen, damit der Spannungsverlauf an den Stromverlauf angeglichen wird. Allgemein ausgedrückt steuert die Recheneinheit den Frequenzgenerator so an, dass ein zeitlicher Versatz zwischen Spannungsverlauf und Stromverlauf reduziert bzw. eliminiert wird, damit die Last, welche von dem Frequenzgenerator mit Energie versorgt wird, in Resonanz betrieben wird.

Um den Frequenzgenerator bei der jeweiligen Resonanzfrequenz zu betreiben, müssen die Zeitpunkte der Nulldurchgänge des Spannungs- und Stromverlaufs zuverlässig erkannt werden, weil diese Zeitpunkte dafür herangezogen werden, den zeitlichen Versatz zwischen der Phase der Spannung und der Phase des Stroms zu ermitteln, und dieser zeitliche Versatz wiederum die Grundlage dafür ist, dass die Recheneinheit das Schaltwerk zum Bereitstellen des Spannungsverlaufs ansteuert, um den zeitlichen Versatz zu minimieren oder gar zu eliminieren.

Das System in seiner Gesamtheit, also die Kombination aus Frequenzgenerator und Last, sowie die einzelnen Komponenten des Systems, also Frequenzgenerator oder Last und Verbindungselemente zwischen Frequenzgenerator und Last, können Oberwellen oder Störungen in den Spannungs- und Stromverlauf einbringen. Diese Oberwellen und Störungen können sich negativ auf die Zuverlässigkeit der erfassten Nulldurchgänge auswirken, beispielsweise weil Oberwellen auf den Strom- und Spannungsverläufen zu weiteren Nulldurchgängen von Strom und Spannung führen, es sich bei diesen weiteren Nulldurchgängen jedoch um aus Störungen resultierende Nulldurchgänge handelt. Wenn diese aus Störungen resultierenden Nulldurchgänge berücksichtigt werden, wird der zeitliche Versatz zwischen Spannungs- und Stromverlauf fehlerhaft bestimmt.

Die hier beschriebene Regelungsvorrichtung setzt an dieser Stelle an und verbessert die Zuverlässigkeit der Erkennung von Nulldurchgängen von Strom- und Spannungsverlauf, indem die Anzahl der aus Störungen resultierenden Nulldurchgänge reduziert oder eliminiert wird.

Dies wird erreicht, indem die Erfassungseinheit, nachdem sie einen Nulldurchgang bei Spannungs- und/oder Stromverlauf erkannt hat, das Erkennen weiterer oder folgender Nulldurchgänge für eine bestimmte Zeitdauer aussetzt. Diese bestimmte Zeitdauer kann eine variable Zeitdauer sein, die abhängig ist von der eingestellten Frequenz des Strom- bzw. Spannungsverlaufs. Insbesondere kann die Zeitdauer in Abhängigkeit der Frequenz des Strom- bzw. Spannungsverlaufs angegeben werden, also nicht zwingend als absolute Zeitdauer, sondern bezogen auf die Periodendauer des Strom- bzw. Spannungsverlaufssignals. Die Zeitspanne, in der das Erkennen der Sperrdauer blockiert ist, kann als Sperrzeit bezeichnet werden.

So kann beispielsweise ausgehend von der aktuellen Periodendauer des Strom- und Spannungsverlaufs das Erkennen des jeweils folgenden Nulldurchgangs für die Dauer von 75% der jeweiligen Periodendauer ausgesetzt bzw. unterdrückt werden. In diesem Beispiel ist das Erkennen des folgenden Nulldurchgangs eine Viertel Periode vor dem nächsten erwarteten Nulldurchgang (basierend auf der aktuellen Periodendauer) wieder möglich. Dies ermöglicht es, dass ein Nulldurchgang auch dann erkannt wird, wenn er früher eintritt als der basierend auf der aktuellen Periodendauer erwartete Nulldurchgang. Die Sperrzeit beträgt also einen vorgebbaren und variablen Teil bezogen auf die aktuelle Periodendauer des jeweiligen Signals (Strom- oder Spannungsverlauf). Typischerweise ist die Sperrzeit kleiner als 100% der aktuellen Periodendauer. Die Dauer der Sperrzeit kann variabel definiert werden, und zwar in Abhängigkeit davon, welche Schwankungen bei der Periodendauer der zu erfassenden Signalverläufe in aufeinanderfolgenden Perioden erwartet werden. Wenn zu erwarten ist, dass die Periodendauer von zwei aufeinanderfolgenden Perioden weniger als 20% variiert, dann ist es sinnvoll, die Sperrzeit auf 80% oder knapp darunter zu setzen. In dem obigen Beispiel beträgt die Sperrzeit 75% der aktuellen Periodendauer. Die Sperrzeit schließt sich jeweils an das Erkennen eines Nulldurchgangs an. Sobald ein Nulldurchgang erkannt wurde, setzt die Sperrzeit ein, in welcher das Erkennen eines Nulldurchgangs gesperrt ist.

Nach Ablauf der Sperrzeit wird das Erkennen eines Nulldurchgangs wieder ermöglicht. Die Erfassungseinheit kann also einen entsprechenden Eingang, der die zu erkennenden Signale (Strom- und Spannungsverläufe) erkennt, wieder freigeben oder die an diesen Eingängen anliegenden Werte wieder verarbeiten. Der Zeitraum, in welchem Nulldurchgänge wieder erfasst werden, wird als Erfassungszeit bezeichnet. Die Erfassungszeit schließt sich unmittelbar an die Sperrzeit an. Sobald die Sperrzeit beendet ist, beginnt unmittelbar die Erfassungszeit.

Die Erfassungszeit beginnt in dem genannten Beispiel im Anschluss an die 75% der aktuellen Periodendauer andauernden Sperrzeit. Somit kann auch ein Nulldurchgang erfasst werden, der 25% früher eintritt als basierend auf der aktuellen Periodendauer erwartet.

Um auch einen Nulldurchgang zu erkennen, der später eintritt als der basierend auf der aktuellen Periodendauer erwartete Nulldurchgang, wird die Erfassungszeit um denselben Anteil einer Periodendauer über den erwarteten Zeitpunkt des Nulldurchgangs verlängert, um welchen die Sperrzeit kürzer ist als die aktuelle Periodendauer. In dem genannten Beispiel ist die Sperrzeit um 25% kürzer als die aktuelle Periodendauer (die Sperrzeit ist auf 75% der aktuellen Periodendauer festgelegt). Somit dauert die Erfassungszeit für einen Nulldurchgang von einem Zeitpunkt, der 25% der Periodendauer vor dem erwarteten Nulldurchgang liegt, bis zu einem Zeitpunkt, der 25% der Periodendauer nach dem erwarteten Nulldurchgang liegt.

Sobald in dem Erfassungszeitraum ein Nulldurchgang des Strom- und/oder Spannungsverlaufs erkannt wird, wird die aktuelle Periodendauer neu berechnet und basierend auf der neu berechneten aktuellen Periodendauer werden die Sperrzeit und die Erfassungszeit für die nächste Periode vorgegeben.

Die Sperrzeit und die Erfassungszeit können mit Hilfe von Halbleiterelementen implementiert werden. Beispielsweise kann ein Schaltkreis verwendet werden, welcher unter Nutzung von flankengesteuerten Flip-Flops das Erkennen von Nulldurchgängen zulässt, indem ein an einem Eingang des Flip-Flops anliegendes Signal (Strom- und/oder Spannungsverlauf) für die weitere Verarbeitung weitergeleitet wird oder nicht. Indem die Flip-Flops mit einem entsprechenden Arbeitssignal mit eigener Frequenz betrieben werden, kann der Zeitraum, in welchem die Flip-Flops das an ihrem Eingang anliegende Signal für die weitere Verarbeitung in der Erfassungseinheit weitergeben oder nicht, vorgegeben werden. Das Arbeitssignal hat eine Frequenz, die höher ist als die Frequenz der zu erkennenden Strom- und Spannungsverläufe hat. Damit kann über flankengesteuerte Flip-Flops, die von den steigenden oder fallenden Flanken des Arbeitssignals gesteuert werden, der Beginn und das Ende der Sperrzeit sowie der Beginn und das Ende der Erfassungszeit definiert werden. Weil die Frequenz des Arbeitssignals höher ist als die Frequenz der zu erkennenden Strom- und Spannungsverläufe und das Ende der Sperrzeit typischerweise auf eine steigende oder fallende Flanke des Arbeitssignals fällt, ist die Sperrzeit kürzer als die Periodendauer der zu erkennenden Strom- und Spannungsverläufe.

Weil nach dem Erkennen eines Nulldurchgangs in Strom- und/oder Spannungsverlauf das Erkennen des folgenden Nulldurchgangs für die Sperrzeit blockiert ist, werden solche Nulldurchgänge, die durch Störungen wie Oberwellen verursacht werden, nicht fälschlicherweise als echte Nulldurchgänge erkannt.

Solche fälschlicherweise erkannten Nulldurchgänge, die auf Störungen basieren, können das Einstellen der Resonanzfrequenz das Frequenzgenerators stark erschweren. Indem die Erfassungseinheit für das Erkennen von validen Nulldurchgängen eine Erfassungszeit mit vorgebbarer Zeitdauer nutzt, wird der Frequenzgenerator rascher auf die jeweils passende Resonanzfrequenz eingestellt bzw. der Frequenzgenerator kann rascher auf Änderungen der Resonanzfrequenz reagieren und stellt sich auch auf die passende Resonanzfrequenz ein.

Gemäß der Erfindung ist die Erfassungseinheit ausgeführt, das erneute Erkennen eines Nulldurchgangs des Spannungsverlaufs und/ oder eines Nulldurchgangs des Stromverlaufs nach Ablauf der Sperrzeit für die Dauer einer Erfassungszeit zuzulassen. Die Erfassungszeit schließt sich unmittelbar an die Sperrzeit an, und hat eine Dauer, die dem Doppelten der Differenz zwischen der aktuellen Periodendauer des Spannungsverlaufs und/oder des Stromverlaufs und dem Anteil der Sperrzeit an dieser aktuellen Periodendauer entspricht.

Ausgehend von dem oben herangezogenen Beispiel hat die Sperrzeit eine Dauer von 75% der aktuellen Periodendauer von Strom- und/oder Spannungsverlauf. Die Erfassungszeit beginnt also eine Vierte Periode vor dem nächsten erwarteten Nulldurchgang (basierend auf der aktuellen Periodendauer). Die Erfassungszeit endet jedoch nicht bei dem erwarteten Zeitpunkt des nächsten Nulldurchgangs, sondern dauert länger als dieser erwartete Zeitpunkt, um auch später eintretende Nulldurchgänge zu erfassen.

In diesem Beispiel beträgt die Differenz zwischen der aktuellen Periodendauer des Spannungsverlaufs und/ oder des Stromverlaufs und dem Anteil der Sperrzeit an dieser aktuellen Periodendauer also 25%, weil die aktuelle Periodendauer mit 100% festgelegt ist und die Sperrzeit einen Anteil von 75% daran hat. Die Erfassungszeit hat eine Dauer, die dem Doppelten dieser Differenz entspricht, also 50% der aktuellen Periodendauer.

Gemäß einer weiteren Ausführungsform ist die Erfassungseinheit ausgeführt, einen während der Erfassungszeit erkannten Nulldurchgang an die Recheneinheit zu übertragen. Die Recheneinheit ist ausgeführt, basierend auf dem während der Erfassungszeit erkannten Nulldurchgang die aktuelle Periodendauer des erfassten Strom- und/oder Spannungsverlaufs neu zu ermitteln. Die Recheneinheit ist ausgeführt, basierend auf der neu ermittelten Periodendauer des erfassten Strom- und/oder Spannungsverlaufs die Sperrzeit und die Erfassungszeit neu zu definieren.

Beispielsweise kann die Recheneinheit die neue Dauer von Sperrzeit und Erfassungszeit an die Erfassungseinheit übertragen. Die Recheneinheit kann aber auch die neu berechnete Periodendauer des erfassten Strom- und/oder Spannungsverlaufs an die Erfassungseinheit übertragen und die Sperrzeit und die Erfassungseinheit ergibt sich automatisch aus der neu berechneten Periodendauer als Anteil (im obigen Beispiel: Sperrzeit = 75% der neu berechneten Periodendauer, Erfassungszeit = 2 x 25% der neu berechneten Periodendauer) hiervon.

Wenn die Erfassung von Nulldurchgängen durch flankengesteuerte Flip-Flops gesperrt oder zugelassen wird, kann das Arbeitssignal in Abhängigkeit der neu berechneten Periodendauer des erfassten Strom- und/oder Spannungsverlaufs verändert werden, so dass der prozentuale Anteil der Sperrzeit und der Erfassungszeit an der Periodendauer des erfassten Strom- und/oder Spannungsverlaufs gleichbleibt. Die Sperrzeit und die Erfassungszeit müssen nicht zwingend als Werte berechnet werden, sondern ergeben sich automatisch als Anteil der neu berechneten Periodendauer des erfassten Strom- und/oder Spannungsverlaufs und aus der angepassten Frequenz des Arbeitssignals der Flip-Flops.

In anderen Worten werden die Sperrzeit und die Erfassungszeit durch eine neu ermittelte Periodendauer des erfassten Strom- und/oder Spannungsverlaufs mittelbar definiert, weil sich die Sperrzeit und die Erfassungszeit über einen vorgegebenen Anteil der neu berechneten Periodendauer erstrecken und damit unmittelbar von der neu berechneten Periodendauer abhängen.

Gemäß einer weiteren Ausführungsform schließt sich die neu definierte Sperrzeit unmittelbar an den während der Erfassungszeit erkannten Nulldurchgang an.

Sobald während der Erfassungszeit ein Nulldurchgang erfasst wird, schließt sich die neu definierte Sperrzeit an diesen Nulldurchgang an. D.h. dass die Regelungsvorrichtung für die nächste Periode des zu erfassenden Strom- und/oder Spannungsverlaufs mit der neu definierten Sperrzeit und der neu definierten Erfassungszeit arbeitet.

Ob ein Nulldurchgang als valider Nulldurchgang erfasst wird, hängt also stets von der Periodendauer des erfassten Strom- und/oder Spannungsverlaufs ab. Wenn sich diese Periodendauer ändert, dann ändert sich auch die Dauer der Sperrzeit und der Erfassungszeit. Sprunghafte Veränderungen in der Periodendauer, also solche Veränderungen, bei denen sich die Periodendauer zweier aufeinanderfolgender Perioden um mehr als die Hälfte der Erfassungszeit ändert, werden damit für die Anpassung der Schaltfrequenz des Spannungsverlaufs nicht berücksichtigt.

Gemäß einer weiteren Ausführungsform weist die Erfassungseinheit einen Tiefpass auf, wobei der Tiefpass ausgeführt ist, Signalanteile des erfassten Strom- und/oder Spannungsverlaufs, die einen vorgebbaren Frequenzschwellwert überschreiten, zu filtern.

Damit wird der Effekt von Oberwellen oder anderen Störungen des erfassten Strom- und/oder Spannungsverlaufs reduziert und die Anzahl der Nulldurchgänge, die durch die Oberwellen oder Störungen (invalide Nulldurchgänge, falsche Nulldurchgänge) verursacht werden, wird reduziert.

Durch den Tiefpass werden beispielsweise Signalanteile gefiltert, die eine Frequenz haben, die mindestens drei bis vier Mal höher ist als die Frequenz der Grundwelle.

Gemäß einer weiteren Ausführungsform ist die Erfassungseinheit ausgeführt, den Zeitpunkt eines Nulldurchgangs des Spannungsverlaufs und/oder den Zeitpunkt eines Nulldurchgangs des Stromverlaufs zu erkennen, nachdem der erfasste Strom- und/oder Spannungsverlauf von dem Tiefpass gefiltert wurde.

Das bedeutet, dass die erfassten Verläufe von Strom und/oder Spannung zunächst einer Filterung durch den Tiefpass zugeführt werden, bevor die Erkennung der Nullstellen durch die Erfassungseinheit erfolgt. Der Tiefpass filtert somit Störungen auf den erfassten Strom- und/oder Spannungsverläufen und sorgt für eine zuverlässigere Erkennung von Nullstellen der Grundwelle, also des unverfälschten (tatsächlichen) Verlaufs von Strom und/oder Spannung.

Gemäß einer weiteren Ausführungsform weist die Regelungsvorrichtung ein Verzögerungsglied auf, wobei das Verzögerungsglied ausgestaltet ist, dem Zeitpunkt eines erfassten Nulldurchgangs des Spannungsverlaufs und/oder eines erfassten Nulldurchgangs des Stromverlaufs eine Verzögerung hinzuzufügen, bevor die Recheneinheit den zeitlichen Versatz (Δt₁, Δt₂) zwischen einer Flanke des Stromverlaufs und einer zugehörigen Flanke des Spannungsverlaufs ermittelt.

Durch das Verzögerungsglied wird eine Verzögerung in den Zeitpunkt der erfassten Nullstellen eingebracht.

Je nachdem, welche Halbleiterelemente in der Regelungsvorrichtung verwendet werden, können diese von sich aus eine Verzögerung in die Schaltvorgänge einbringen, was zu einer fehlerhaften Ermittlung des zeitlichen Versatzes zwischen Stromverlauf und Spannungsverlauf führen kann. Die von dem Verzögerungsglied eingebrachte Verzögerung in den Zeitpunkt der erfassten Nullstellen gleicht die Verzögerung in den Halbleiterelementen aus. Werden beispielsweise MOSFETs verwendet, so kann es sinnvoll sein, spannungslos zu schalten. Werden kapazitiv belastete Schaltelemente genutzt, wie beispielsweise MOSFETs, so wird der Zeitpunkt des Nulldurchgangs des Spannungsverlaufs verzögert, um an dem kapazitiv belasteten Schaltelement spannungslos zu schalten.

Das Verzögerungsglied kann mit zwei Werten versorgt werden: die aktuelle Periodendauer bzw. Frequenz und das Ausmaß der Verzögerung.

Das Ausmaß der Verzögerung kann ein Phasenversatz sein, der abhängig ist von der Kapazität des kapazitiv belasteten Schaltelements. Insbesondere ist der Phasenversatz proportional zu dieser Kapazität.

Diese durch das Verzögerungsglied eingebrachte Verzögerung kompensiert parasitär eingebrachte Verzögerungen der Zeitpunkte der Nulldurchgänge und erhöht damit die Genauigkeit des ermittelten zeitlichen Versatzes zwischen einer Flanke des Stromverlaufs und einer zugehörigen Flanke des Spannungsverlaufs, wodurch das Einstellen der Resonanzfrequenz an dem Frequenzgenerator mit einer höheren Genauigkeit erfolgen kann.

Gemäß einer weiteren Ausführungsform ist die Verzögerung ein Phasenversatz, der sich auf die Periodendauer des erfassten Strom- und/oder Spannungsverlaufs bezieht.

Der Phasenversatz ist üblicherweise ein Versatz um einen bestimmten Anteil an der Periodendauer, welcher bezogen auf die Phase gleichbleibt. Die absolute zeitliche Dauer hingegen variiert, wenn sich die Periodendauer des erfassten Stromverlaufs und/oder Spannungsverlaufs ändert.

Gemäß einem zweiten Aspekt ist ein Ionentriebwerk angegeben. Das Ionentriebwerk weist einen Frequenzgenerator und eine Regelungsvorrichtung wie oben und im Folgenden beschrieben auf. Der Frequenzgenerator ist ausgeführt zum Abgeben von elektrischer Energie mit einer vorgebbaren Frequenz für den Strom- und Spannungsverlauf der elektrischen Energie, um in dem Ionentriebwerk ein elektrisches Feld zu erzeugen. Dabei ist die Regelungsvorrichtung mit dem Frequenzgenerator gekoppelt, um den Frequenzgenerator bei einer vorgegebenen Frequenz zu betreiben, so dass ein Treibstoff in dem elektrischen Feld ionisiert wird.

Ein solches Ionentriebwerk kann beispielsweise in der Raumfahrt verwendet werden, um Raumfahrzeuge anzutreiben. Das Ionentriebwerk kann auch in Satelliten verwendet werden. Dabei kann das Ionentriebwerk dafür verwendet werden, den Satelliten in eine vorgegebene Umlaufbahn zu bringen oder in der vorgegebenen Umlaufbahn zu halten.

Die oben beschriebene Regelungsvorrichtung hat den Vorteil, dass die Resonanzfrequenz der Strom- und Spannungsverläufe für das Betreiben des Ionentriebwerks zuverlässig und mit hoher Genauigkeit eingestellt werden kann. Es ist auch möglich, eine Triebwerkseinheit (Plasmakammer, Spule, und andere an der Plasmakammer angeordnete Komponenten) zu tauschen oder eine elektrische Verbindung mit einer größeren Leitungslänge zwischen dem Frequenzgenerator und der Triebwerkseinheit zu verwenden, weil die hier beschriebene Regelungsvorrichtung Störungen durch die elektrische Verbindung und Abweichungen der Anpassung zwischen Triebwerkseinheit und Frequenzgenerator ausgleicht bzw. sich auf diese Abweichungen einstellt und dennoch in der Lage ist, zuverlässig die Resonanzfrequenz einzustellen.

Gemäß einer Ausführungsform weist der Frequenzgenerator einen Schwingkreis auf und der Schwingkreis ist ein R-L-C-Schwingkreis.

Gemäß einer weiteren Ausführungsform weist der Frequenzgenerator ein Halbleiter-Schaltwerk auf, welches mit dem Schwingkreis gekoppelt ist und ausgeführt ist, den Schwingkreis gemäß dem Schaltsignal der Regelungsvorrichtung anzusteuern.

Im Folgenden Maßnahmen für plasmaenergetische Schutzeinrichtungen in einem Ionentriebwerk beschrieben. Die plasmaenergetischen Schutzeinrichtungen dienen dazu, einen Leistungsüberschlag von einer Triebwerkseinheit auf eine Leistungsversorgungseinheit des Ionentriebwerks aufzunehmen, um Beschädigungen an der Leistungsversorgungseinheit zu vermeiden. Als Maßnahmen für plasmaenergetische Schutzeinrichtungen werden eine Energiekompensationseinheit, eine Anpassungseinheit und eine Störungsunterdrückungseinheit beschrieben, die jeweils einzeln oder in Kombination mit einer oder beiden anderen Maßnahmen in einem hierin beschriebenen Ionentriebwerk implementiert werden können. Diese plasmaenergetischen Schutzeinrichtungen können zusammen mit der oben beschriebenen Regelungsvorrichtung in einem Ionentriebwerk verwendet werden.

Das Ionentriebwerk weist in einer Ausführungsform eine Triebwerkseinheit und eine Leistungsversorgungseinheit mit einem Schaltwerk auf. Das Schaltwerk weist eine Energiekompensationseinheit auf. Die Energiekompensationseinheit ist ausgangsseitig in dem Schaltwerk angeordnet und ist ausgestaltet, einen Leistungsüberschlag von der Triebwerkseinheit auf die Leistungsversorgungseinheit mindestens teilweise aufzunehmen. Die Energiekompensationseinheit ist als kapazitätsarme bipolare Spannungsbegrenzung ausgestaltet.

Die Triebwerkseinheit ist allgemein die Einheit, welche mit elektrischer Energie versorgt wird und die Schubkraft erzeugt. Die Leistungsversorgungseinheit enthält beispielsweise einen Frequenzgenerator und eine Regelungsvorrichtung wie hierin beschrieben und stellt elektrische Energie für die Triebwerkseinheit bereit.

Das hier beschriebene Ionentriebwerk kann mit einer Regelungsvorrichtung wie im Zusammenhang mit einigen oder allen Aspekten und Ausführungsformen aus dieser Beschreibung dargelegt, betrieben werden. Allerdings ist es auch möglich, das Ionentriebwerk gemäß diesem Aspekt mit einer herkömmlichen Regelungsvorrichtung ohne einige Merkmale der Regelungsvorrichtung gemäß anderen hierin beschriebenen Aspekten und Ausführungsformen der Regelungsvorrichtung zu verwenden.

Die Energiekompensationseinheit dient dazu, einen Leistungsüberschlag, wie beispielsweise einen Spannungsüberschlag, von der Triebwerkseinheit auf die Leistungsversorgungseinheit aufzunehmen und dadurch zu verhindern, dass der Leistungsüberschlag auf die weiteren elektronischen Komponenten der Leistungsversorgungseinheit wirkt und diese beschädigt.

In einem Ionentriebwerk gibt es typischerweise zwei Leistungskreise: einen ersten elektrischen Leistungskreis in der Triebwerkseinheit, um das Plasma zu erzeugen und ionisierte Teilchen zu beschleunigen, wodurch die Schubkraft erzeugt wird, und einen zweiten Leistungskreis in der Leistungsversorgungseinheit, welche die elektrische Energie erzeugt und bereitstellt. Ein Leistungsüberschlag von einem Leistungskreis auf den anderen Leistungskreis kann die Funktion des Ionentriebwerks auf unerwünschte Weise beeinflussen. So kann insbesondere ein Leistungsüberschlag aus der Triebwerkseinheit auf die Leistungsversorgungseinheit unerwünscht sein. Bei einem solchen Leistungsüberschlag wird beispielsweise Energie aus der Triebwerkseinheit über das Plasma in der Plasmakammer auf die Leistungsversorgungseinheit geleitet. Hierbei können elektronische Komponenten der Leistungsversorgungseinheit beschädigt werden. Um dies zu vermeiden, ist eine Energiekompensationseinheit in dem Schaltwerk angeordnet. Diese nimmt einen Spannungsüberschlag aus der Plasmakammer auf die Leistungsversorgungseinheit auf und schützt dadurch die übrigen elektronischen Komponenten der Leistungsversorgungseinheit.

Gemäß einer Ausführungsform weist die Energiekompensationseinheit einen ersten Zweig und einen zweiten Zweig auf, wobei der erste Zweig eine erste Hochspannungsdiode und eine dazu in Reihe und gegenläufig geschaltete erste Suppressordiode aufweist, wobei der zweite Zweig eine zweite Hochspannungsdiode und eine dazu in Reihe und gegenläufig geschaltete zweite Suppressordiode aufweist, wobei die erste Hochspannungsdiode gegenläufig zu der zweiten Hochspannungsdiode geschaltet ist, und wobei die erste Suppressordiode gegenläufig zu der zweiten Suppressordiode geschaltet ist.

Durch diesen Aufbau ermöglicht die Energiekompensationseinheit eine bipolare Spannungsbegrenzung und ist dazu kapazitätsarm. Eine solchermaßen gestaltete Energiekompensationseinheit dient dazu, möglichst viel Energie aus einem Leistungsüberschlag in der Triebwerkseinheit aufzunehmen und von den übrigen elektronischen Komponenten der Leistungsversorgungseinheit fernzuhalten.

Das Ionentriebwerk weist in einer Ausführungsform eine Triebwerkseinheit und eine Leistungsversorgungseinheit mit einem Schaltwerk auf. Das Schaltwerk weist eine Anpassungseinheit auf. Die Anpassungseinheit weist eine erste Schnittstelle und eine zweite Schnittstelle auf. Die Anpassungseinheit ist ausgeführt, über die zweite Schnittstelle elektrische Energie von elektronischen Komponenten der Leistungsversorgungseinheit aufzunehmen und über die erste Schnittstelle elektrische Energie zu der Triebwerkseinheit abzugeben. Die erste Schnittstelle ist von der zweiten Schnittstelle galvanisch getrennt.

Für den allgemeinen Aufbau eines Ionentriebwerks wird auf die Beschreibung des Ionentriebwerks gemäß anderen Aspekten und Beispielen in dieser Beschreibung verwiesen.

Durch den Aufbau des Ionentriebwerks mit einer Anpassungseinheit wird eine galvanische Trennung zwischen der Triebwerkseinheit einerseits und übrigen elektronischen Komponenten der Leistungsversorgungseinheit andererseits implementiert. Ein Leistungsüberschlag aus der Triebwerkseinheit in die Leistungsversorgungseinheit kann damit unterdrückt werden.

Die Anpassungseinheit kann beispielsweise eine erste Spule an der ersten Schnittstelle und eine zweite Spule an der zweiten Schnittstelle enthalten. Elektrische Energie in Form von Wechselstrom wird in die zweite Spule eingespeist, auf die erste Spule übertragen und von dort an die Triebwerkseinheit weitergegeben. Zwischen der ersten und zweiten Spule kann ein Kern angeordnet sein.

In der Anpassungseinheit ist damit die Funktion eines Transformators implementiert. Hier kann auch ein Transformationsverhältnis zwischen der ersten Schnittstelle und der zweiten Schnittstelle implementiert werden. Eine Spule, beispielsweise die zweite Spule, kann über eine Kapazität mit Masse verbunden sein.

Die Anpassungseinheit kann auch dazu beitragen, eine bessere elektrische Anpassung der Leistungsversorgungseinheit an die Triebwerkseinheit zu ermöglichen, wodurch ein besserer Wirkungsgrad des Ionentriebwerks ermöglicht wird.

Die Anpassungseinheit kann zusammen mit oder losgelöst von der oben beschriebenen Energiekompensationseinheit in einem Ionentriebwerk verwendet werden. Ebenso kann die Anpassungseinheit in einem Ionentriebwerk zusammen mit oder losgelöst von der Regelungsvorrichtung gemäß anderen hierin beschriebenen Aspekten und Ausführungsformen verwendet werden.

Das Ionentriebwerk weist in einer Ausführungsform eine Triebwerkseinheit, eine Leistungsversorgungseinheit, und eine Störungsunterdrückungseinheit auf. Die Störungsunterdrückungseinheit ist an einer Schnittstelle zwischen der Leistungsversorgungseinheit und der Triebwerkseinheit angeordnet und ist ausgestaltet, Störungen in einer elektrischen Verbindung zwischen der Leistungsversorgungseinheit und der Triebwerkseinheit aufzunehmen und zu unterdrücken. Die Störungsunterdrückungseinheit weist eine als Spannungsteiler miteinander verschaltete Induktivität und eine Kapazität auf. Die elektrische Verbindung verbindet die Triebwerkseinheit mit einem Knoten zwischen der Induktivität und der Kapazität.

Für den allgemeinen Aufbau eines Ionentriebwerks wird auf die Beschreibung des Ionentriebwerks gemäß anderen Aspekten und Beispielen in dieser Beschreibung verwiesen.

Durch den Aufbau des Ionentriebwerks mit einer Störungsunterdrückungseinheit werden Oberwellen und Störungen in der elektrischen Verbindung zwischen Leistungsversorgungseinheit und Triebwerkseinheit unterdrückt. Insbesondere Störungen und Oberwellen, die aus einem Leistungsüberschlag aus der Triebwerkseinheit in die Leistungsversorgungseinheit resultieren, können damit unterdrückt werden. Selbstverständlich dient die Störungsunterdrückungseinheit auch dazu, Störungen und Oberwellen, die eine andere Ursache haben, zu unterdrücken, wie beispielsweise Störungen und Oberwellen, die aus der elektrischen Verbindung zwischen Leistungsversorgungseinheit und Triebwerkseinheit resultieren. Damit trägt die Störungsunterdrückungseinheit dazu bei, dass längere elektrische Leitungen zwischen Leistungsversorgungseinheit und Triebwerkseinheit verwendet werden können, als wenn keine Störungsunterdrückungseinheit verwendet wird.

Die Störungsunterdrückungseinheit besteht insbesondere aus einem L-C-Spannungsteiler. Ein Kondensator aus dem Schwingkreis, der in einem Ionentriebwerk sowieso vorhanden ist, kann verwendet werden, um diesen L-C-Spannungsteiler umzusetzen. Die Induktivität und die Kapazität der Störungsunterdrückungseinheit realisieren zusammen mit der Spule der Triebwerkseinheit einen L-C-L-Schwingkreis, was zur Stabilisierung der Frequenz der elektrischen Signale auf der Leitung zwischen Leistungsversorgungseinheit und Triebwerkseinheit beiträgt.

Die Störungsunterdrückungseinheit kann zusammen mit oder losgelöst von der oben beschriebenen Energiekompensationseinheit und/oder der Anpassungseinheit in einem Ionentriebwerk verwendet werden. Ebenso kann die Störungsunterdrückungseinheit in einem Ionentriebwerk zusammen mit oder losgelöst von der Regelungsvorrichtung gemäß anderen hierin beschriebenen Aspekten und Ausführungsformen verwendet werden.

### Kurze Beschreibung der Figuren

Nachfolgend werden anhand der beigefügten Zeichnungen einige Details näher beschrieben. Die Darstellungen sind schematisch und nicht maßstabsgetreu. Gleiche Bezugszeichen beziehen sich auf gleiche oder ähnliche Elemente. Es zeigen:
- Fig. 1: eine schematische Darstellung eines Ionentriebwerks.
- Fig. 2: eine schematische Darstellung der funktionalen Einheiten eines Ionentriebwerks.
- Fig. 3: eine schematische Darstellung eines Strom- und Spannungsverlaufs eines Schwingkreises eines Ionentriebwerks.
- Fig. 4: eine schematische Darstellung eines erfassten Signalverlaufs mit Grundwelle und Oberwelle.
- Fig. 5: eine schematische Darstellung eines Spannungsverlaufs mit Darstellung der Zeiträume für die Erfassung von Nulldurchgängen.
- Fig. 6: eine schematische Darstellung von funktionalen Einheiten eines Ionentriebwerks mit zusätzlichen Maßnahmen für plasmaenergetische Schutzeinrichtungen.
- Fig. 7: eine schematische Darstellung von funktionalen Einheiten eines Ionentriebwerks mit zusätzlichen Maßnahmen für plasmaenergetische Schutzeinrichtungen.
- Fig. 8: eine schematische Darstellung einer Energiekompensationseinheit für ein Ionentriebwerk.
- Fig. 9: eine schematische Darstellung einer Anpassungseinheit für ein Ionentriebwerk.
- Fig. 10: eine schematische Darstellung einer Störungsunterdrückungseinheit für ein Ionentriebwerk.

### Detaillierte Beschreibung

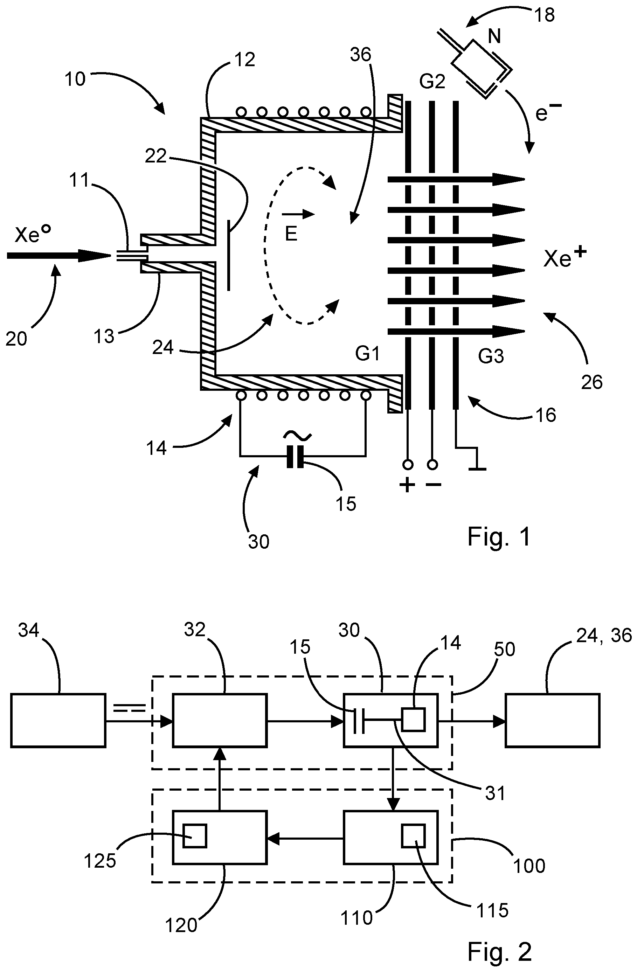

Fig. 1 zeigt eine schematische Darstellung eines Ionentriebwerks 10. Das Ionentriebwerk 10 weist ein Gehäuse 12 sowie einen Schwingkreis 30 mit einer Spule 14 auf. Die Spule 14 ist so an dem Gehäuse 12 angeordnet, dass ein elektrisches Feld 24 im Innenraum des Gehäuses 12 erzeugt werden kann. Dem Gehäuse 12 wird über eine Leitung 11 ein Treibstoff 20 zugeführt. Bei dem Treibstoff kann es sich beispielsweise um ein Edelgas, wie beispielsweise Xenon, handeln. Es ist auch denkbar, dass andere Treibstoffe genutzt werden, wie beispielsweise Jod. Die Leitung 11 ist beispielsweise eine metallische Leitung oder ein metallisches Rohr. Die Leitung 11 ist mit dem Anschluss 13 des Gehäuses 12 gekoppelt, so dass Treibstoff aus der Leitung 11 über den Anschluss 13 in das Gehäuse 12 transportiert werden kann. In dem Innenraum des Gehäuses 12 ist eine Katode 22 angeordnet, um die Teilchen des Treibstoffs 20 in Zusammenwirkung mit dem elektrischen Feld 24 zu ionisieren. In dem Innenraum des Gehäuses 12 befindet sich Plasma 36. Eine Gitteranordnung 16 mit den Gittern G1, G2, G3 ist angeordnet, die ionisierten Teilchen des Treibstoffs 20 zu beschleunigen und in einen Ionenstrom 26 zu überführen, welcher eine Kraft nach dem Rückstoßprinzip hervorruft. Um den aus dem Gehäuse 12 austretenden Ionenstrom 26 zu neutralisieren ist eine Neutralisiereinheit 18 vorgesehen.

Der Schwingkreis 30 ist bevorzugt bei seiner Resonanzfrequenz zu betreiben, um die elektrischen Verluste zu reduzieren und für einen effektiven Antrieb des Ionentriebwerks zu sorgen. Der Schwingkreis 30 wird gebildet von der Kapazität 15 und der Spule 14, welche sich um das Gehäuse 12 erstreckt. Das Plasma 36 hat Einfluss auf die Induktivität der Spule 14, so dass sich deren Kopplung ändert. Damit wird die Spule 14 zu einer dynamischen Induktivität, d.h., dass sich ihr Induktivitätswert in Abhängigkeit des Betriebs des Ionentriebwerks ändert, womit sich auch die Resonanzfrequenz des Schwingkreises 30 ändert. Aus diesem Grunde muss sowohl die Frequenz als auch die Pulsweite des Schwingkreises 30 geregelt werden.

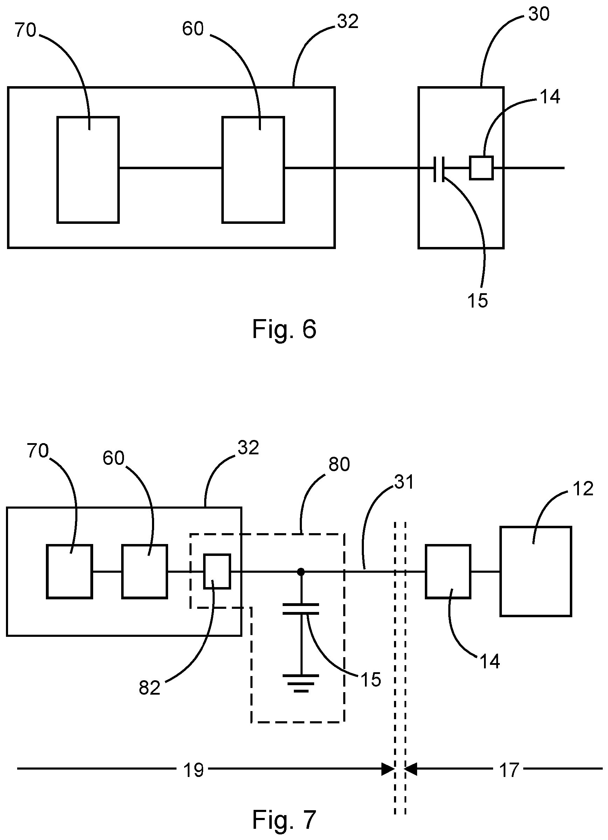

Die Kapazität 15 ist als ein elektrischer Kondensator ausgestaltet und ist üblicherweise Bestandteil einer Leistungsversorgungseinheit 19 (siehe Fig. 7), wohingegen die Spule 14 der Triebwerkseinheit 17 (siehe Fig. 7) zugeordnet ist. Die Spule 14 und die Kapazität 15 sind mit einer elektrischen Leitung 31 (siehe Fig. 2 und Fig. 7) verbunden, so dass elektrische Energie an die Triebwerkseinheit übertragen werden kann. Die elektrische Leitung 31 ermöglicht es, die Triebwerkseinheit räumlich von der Leistungsversorgungseinheit zu trennen bzw. voneinander beabstandet zu montieren.

Fig. 2 zeigt schematisch den funktionalen Aufbau eines Ionentriebwerks und dessen Komponenten, hauptsächlich die Regelung des elektrischen Feldes 24 bzw. der Last 36 mit dem Plasma. Eine Spannungsversorgung 34 stellt elektrische Energie für den Betrieb des Frequenzgenerators 50 und der Regelungsvorrichtung 100 zur Verfügung. Der Frequenzgenerator 50 weist ein Schaltwerk 32 und einen Schwingkreises 30 auf. Das Schaltwerk 32 ist ausgeführt, einen Spannungswert so zu schalten, dass der Schwingkreis 30 mit Spannung versorgt und bei einer vorgegebenen Frequenz betrieben wird.

Der Schwingkreis 30 wird von der Kapazität 15 und der Spule 14 gebildet, welche mit der Leitung 31 elektrisch miteinander verbunden sind.

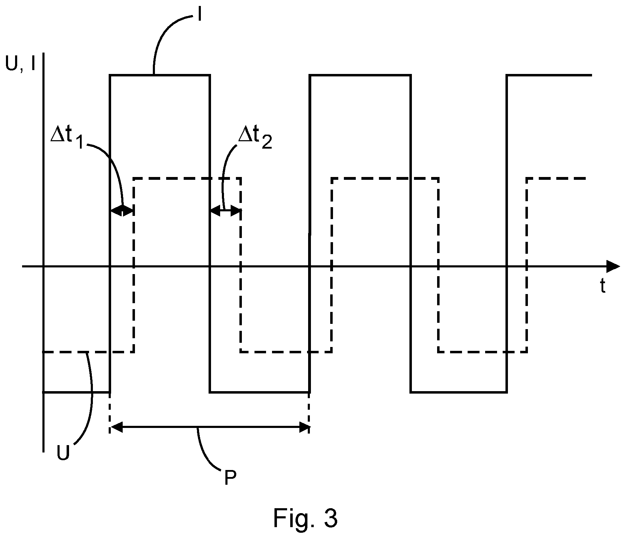

Die Frequenz des Schwingkreises 30 wird von der Regelungsvorrichtung 100 überwacht und geregelt. Zu diesem Zweck weist die Regelungsvorrichtung 100 eine Erfassungseinheit 110 und eine Recheneinheit 120 auf. Die Erfassungseinheit 110 ist ausgeführt, den Stromverlauf und den Spannungsverlauf an dem Schwingkreis 30 zu erfassen, wie dies anschaulich weiter unten mit Bezug zu Fig. 3 beschrieben wird. Basierend auf den erfassten Werten der Erfassungseinheit 110 ermittelt die Recheneinheit 120 eine Phasenlage des Stromverlaufs und des Spannungsverlaufs, um basierend auf dieser Phasenlage ein Schaltverhalten des Schaltwerks 32 zumindest mittelbar zu beeinflussen.

Die Erfassungseinheit 110 weist einen Tiefpass 115 auf. Dem Tiefpass wird ein erfasster Strom- und/oder Spannungsverlauf zugeführt, damit hieraus Oberwellen ab einem vorgegebenen Frequenzwert gefiltert oder gedämpft werden, damit die Oberwellen keinen schädlichen Einfluss auf die Erkennung von Nulldurchgängen der Strom- und/oder Spannungsverläufe haben.

Die Recheneinheit 120 weist ein Verzögerungsglied 125 auf. Das Verzögerungsglied ist ausgestaltet, einem erfassten und von der Erfassungseinheit 110 bereitgestellten Zeitpunkt eines Nulldurchgangs des Strom- und/oder Spannungsverlaufs eine Verzögerung hinzuzuaddieren, um interne Verzögerungen bei der Verarbeitung der Nulldurchgänge zu kompensieren.

Der Schwingkreis 30 ist angeordnet, ein elektrisches Feld 24 zu erzeugen, so dass ein Ionenstrom in dem Ionentriebwerk hervorgerufen und aufrechterhalten wird, um eine Antriebsenergie bereitzustellen, die beispielsweise für einen Satelliten oder ein Raumfahrzeug genutzt werden kann.

Fig. 3 zeigt einen beispielhaften Strom- (I) und Spannungsverlauf (U) bezogen auf die Zeit (t) sowie die Phasenlage zwischen Strom und Spannung. Strom und Spannung sind jeweils als Rechtecksignale dargestellt, wobei der Stromverlauf mit einer durchgezogenen Linie und der Spannungsverlauf mit einer gestrichelten Linie dargestellt ist. Eine Periode p des Signalverlaufs ist ebenfalls eingezeichnet und erstreckt sich zeitlich jeweils von steigender Flanke zu steigender Flanke bzw. von fallender Flanke zu fallender Flanke.

Dem in Fig. 3 gezeigten Verlauf von Strom und Spannung ist ein Phasenversatz Δt₁ zwischen den steigenden Flanken zu entnehmen. Wird dieser zeitliche Phasenversatz als Differenz zwischen dem Nulldurchgang des Spannungsverlaufs und dem zugeordneten Nulldurchgang des Stromverlaufs definiert, ist der Wert des hier gezeigten zeitlichen Phasenversatzes Δt₁ ein positiver Wert. Es ist natürlich denkbar, dass dieser zeitliche Phasenversatz Δt₁ je nach Charakteristik des Schwingkreises auch negativ sein kann und dass sein absoluter Wert (die zeitliche Dauer) variieren kann.

Neben dem zeitlichen Versatz der steigenden Flanken kommt es in Abhängigkeit der Pulsweite (duty cycle) von Strom und Spannung zu dem zweiten zeitlichen Versatz Δt₂ zwischen den fallenden Flanken. Für den zweiten zeitlichen Versatz gelten die gleichen grundsätzlichen Ausführungen wie bereits mit Bezug zu dem ersten zeitlichen Versatz Δt₁, so dass darauf verwiesen wird.

Im Resonanzfall und auch bei richtig eingestellter Pulsweite gibt es zwischen Stromverlauf und Spannungsverlauf weder bei der steigenden Flanke noch bei der fallenden Flanke einen nennenswerten Phasenversatz. Hingegen kommt es bei kapazitivem Verhalten des Schwingkreises dazu, dass der Strom der Spannung vorauseilt, so dass die Frequenz erhöht werden muss. Andererseits kommt es bei induktivem Verhalten des Schwingkreises dazu, dass die Spannung dem Strom vorauseilt, so dass die Frequenz verringert werden muss.

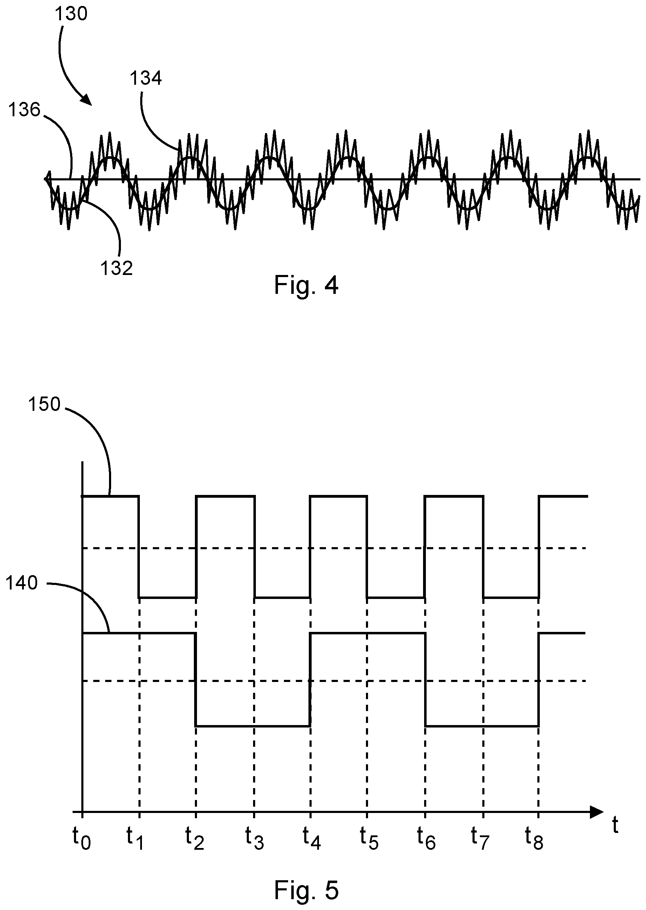

Fig. 4 zeigt beispielhaft und schematisch einen von der Erfassungseinheit 110 erfassten Signalverlauf (vor einer weiteren Verarbeitung durch andere Komponenten), welcher den Spannungsverlauf oder den Stromverlauf darstellt.

Der Signalverlauf 130 stellt eine Überlagerung aus der Grundwelle 132 und einer oder mehreren Oberwellen 134 dar. Die Grundwelle 132 ist beispielsweise ein Sinus-Verlauf oder ein anderer modelltypischen Signalverlauf. Die Oberwelle 134 ist eine die Grundwelle überlagernde Welle mit einer höheren Frequenz als die Frequenz der Grundwelle. Der Signalverlauf 130 schwing periodisch um die Nulllinie 136.

Wie unschwer zu erkennen ist, kann die Oberwelle 134 die Grundwelle 132 derart verfälschen, dass es innerhalb einer kurzen Zeit um den Nulldurchgang der idealen Grundwelle 132 auch weitere Nulldurchgänge geben kann, die von der Oberwelle 134 verursacht werden.

Die Erfassungseinheit 110 kann also mehrere Nulldurchgänge erfassen, was sich auf die Genauigkeit der Einstellung des Frequenzgenerators auswirken kann. Dadurch wird die Resonanzfrequenz an dem Schwingkreis 30 ungenau eingestellt, was zu einem schlechten Wirkungsgrad des Ionentriebwerks führen kann.

Der Tiefpass 115 filtert die Oberwellen 134 aus dem Signalverlauf 130, damit die Anzahl der Nulldurchgänge reduziert wird und insbesondere die von den Oberwellen 134 verursachten "falschen" Nulldurchgänge eliminiert werden.

Fig. 5 zeigt schematisch, wie die Regelungsvorrichtung 100 die Sperrzeit und die Erfassungszeit für die Erfassung von Nulldurchgängen in dem Strom- und/oder Spannungsverlauf in einem Beispiel umsetzt.

Der Signalverlauf 140 stellt schematisch ein Schaltsignal mit einer Schaltsignalfrequenz bzw. Periodendauer dar, die sich über vier Zeitabschnitte von t₀ bis t₄ erstreckt. Der Signalverlauf 140 stellt beispielsweise das Schaltsignal mit der Schaltfrequenz für das Spannungssignal für das Ionentriebwerk dar. Diesem Signalverlauf 140 ist ein zweiter Signalverlauf 150 gegenübergestellt. Der zweite Signalverlauf 150 kann als internes Arbeitssignal des Frequenzgenerators bezeichnet werden. Der zweite Signalverlauf 150 hat eine Frequenz, die höher ist als die Frequenz des Signalverlaufs 140, insbesondere ein ganzzahliges Vielfaches davon ist, beispielsweise doppelt so hoch. Das bedeutet in diesem Beispiel, dass sich eine Periode des zweiten Signalverlaufs 140 über zwei Zeitabschnitte von t₀ bis t₂ erstreckt.

Mit dem zweiten Signalverlauf 150 können Halbleiterelemente, beispielsweise flankengesteuerte Flip-Flops, angesteuert werden, um ein Signal an ihrem Eingang, an dem das zu erfassende Signal (Strom- und/oder Spannungsverlauf) anliegt, für die weitere Verarbeitung durchzuleiten oder zu sperren. Somit kann das Durchleiten oder Sperren eines Signaleingangs an der Erfassungseinheit automatisiert in Hardware implementiert werden, wodurch eine schnelle Reaktion ermöglicht wird.

Sobald bei einem zu erfassenden Signal (z.B. dem Strom- oder Spannungsverlauf an der Energieversorgung des Ionentriebwerks) ein Nulldurchgang detektiert wurde, wird das Erkennen des nächsten Nulldurchgangs für eine einstellbare Zeitspanne gesperrt. Diese Zeitspanne ist abhängig von der Frequenz des zu erfassenden Signals. Beispielsweise wird der nächste Nulldurchgang eines detektierten Signals erst wieder valide erkannt in einer Zeitspanne von -t/4 bis +t/4 des nächsten erwarten Nulldurchgangs basierend auf der aktuell eingestellten Frequenz des zu detektierenden Signals.

In dem Beispiel der Fig. 5 sei ein Nulldurchgang eines Signalverlaufs bei t₀ erkannt worden, dann wird das Erkennen des nächsten Nulldurchgangs für eine Zeitspanne blockiert oder gesperrt; diese Zeitspanne kann auch als Sperrzeit bezeichnet werden. In dem oben genannten Beispiel läuft diese Sperrzeit bis zum Zeitpunkt t₃. Der Zeitpunkt t₃ liegt in diesem Beispiel eine Viertel Periode des Signals 140 vor dem nächsten Nulldurchgang bei t₄. Ab dem Zeitpunkt t₃ werden Nulldurchgänge des erfassten Signals wieder valide erfasst. Bei dem Zeitpunkt t₃ beginnt also die Erfassungszeit für Nulldurchgänge. Die Erfassungszeit erstreckt sich bis zum Zeitpunkt t₅, welcher eine Viertel Periode der aktuell eingestellten Frequenz des zu erfassenden Signals 140 nach dem Zeitpunkt t₄ liegt. Ein valides Erfassen eines Nulldurchgangs ist in der Zeit zwischen t₃ und t₅ möglich. Ab einem erfassten Nulldurchgang bis zum Zeitpunkt t₃ ist das Erfassen eines Nulldurchgangs gesperrt. Üblicherweise sind Veränderungen der Frequenz des zu erfassenden Signals damit ausreichend abgedeckt, d.h. dass die Frequenz sich in der Regel dergestalt verändert, dass trotz veränderter Frequenz der nächste Nulldurchgang in der Erfassungszeit zwischen t₃ und t₅ liegt. Durch diesen Ansatz werden fehlerhafte Nulldurchgangserfassungen reduziert, weil das valide Erfassen der Nulldurchgänge auf einen sinnvollen Zeitraum beschränkt wird.

Das hier beschriebene Beispiel unterstellt, dass die Sperrzeit 75% der aktuellen Periodendauer beträgt, wie weiter oben in der Beschreibung in einem Beispiel ausgeführt. Die Erfassungszeit beträgt dann das doppelte der Differenz aus der erwarteten Periodendauer (ausgehend von der aktuellen Periodendauer wird erwartet, dass der nächste Nulldurchgang bei t₄ erfolgt) und der Sperrzeit. In anderen Worten erstreckt sich die Sperrzeit über drei Zeitspannen von t₀ bis t₃ und die Erfassungszeit über zwei Zeitspannen von t₃ bis t₅.

Fig. 6 zeigt ein Schaltwerk 32 und einen Schwingkreis 30 eines Ionentriebwerks, wie es beispielsweise in Fig. 1 schon beschrieben wurde. Das Schaltwerk 32 führt grundsätzlich die ihm weiter oben zugewiesene Funktion aus. In dem Schaltwerk 32 ist eine Energiekompensationseinheit 60 und eine Anpassungseinheit 70 angeordnet. Die Energiekompensationseinheit 60 und die Anpassungseinheit 70 sind plasmaenergetische Schutzeinrichtungen, um Effekte eines Leistungsübersprungs an dem Ionentriebwerk von der Triebwerkseinheit auf die Leistungsversorgungseinheit abzumildern und Schäden an der Leistungsversorgungseinheit (alles, was aus Sicht der Triebwerkseinheit bzw. aus Sicht des Schwingkreises 30 hinter der Anpassungseinheit 70 angeordnet ist) zu verhindern.

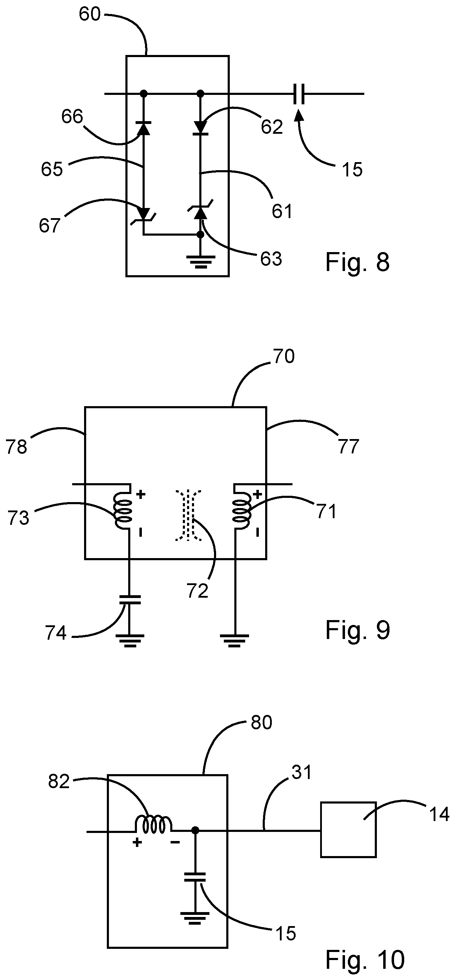

Die Energiekompensationseinheit 60 und die Anpassungseinheit 70 werden weiter unten mit Bezug zu Fig. 8 bzw. Fig. 9 beschrieben.

Ein Leistungsübersprung von der Triebwerkseinheit auf die Leistungsversorgungseinheit kann beispielsweise stattfinden, weil das Gitter G1 der Gitteranordnung 16 Kontakt mit dem Plasma 36 hat, womit eine elektrische Spannung über das Plasma 36 auf den Anschluss 13 und die Treibstoffleitung 11 übertragen wird, so dass die Treibstoffleitung 11 auf demselben Potential ist wie das Gitter G1, siehe Darstellung in Fig. 1. Von der Treibstoffleitung 11 kann es einen Spannungsüberschlag auf die Spule 14 geben, die wiederum Energie in den Kondensator 15 und die Leistungsversorgungseinheit einbringt.

Fig. 7 basiert auf der Darstellung der Fig. 6 und stellt mit der Störungsunterdrückungseinheit 80 neben der Energiekompensationseinheit 60 und der Anpassungseinheit 70 eine zusätzliche plasmaenergetische Schutzeinrichtung dar.

Die Störungsunterdrückungseinheit 80 ist an der Schnittstelle zwischen Leistungsversorgungseinheit 19 und Triebwerkseinheit 17 angeordnet, also an dem Schwingkreis, der von dem Kondensator 15 und der Spule 14 gebildet wird. Die Triebwerkseinheit 17 Die Störungsunterdrückungseinheit 80 selbst weist eine Induktivität 82 auf, die mit dem Kondensator 15 als Spannungsteiler verschaltet ist, wobei der Kondensator 15 auf Masse geführt ist. Die Spule 14 ist elektrisch an dem Knoten zwischen Induktivität 82 und Kondensator 15 angeschlossen.

Bei der Anwendung von Geräten mit Plasma, bei denen das Plasma durch elektrische Wechselfelder erzeugt wird (z.B. in einem Ionentriebwerk), kann es zu Kurzschlüssen oder anderen ungewollten elektrischen Energieeintragungen innerhalb des Gerätes oder über die Systemgrenze hinweg kommen. Diese oftmals energiereichen Vorgänge können zur Zerstörung oder Beschädigung des betroffenen Geräts oder von angrenzenden Geräten oder Komponenten hiervon führen. Die plasmaenergetischen Schutzeinrichtungen (Energiekompensationseinheit 60, Anpassungseinheit 70, Störungsunterdrückungseinheit 80) können solche Beschädigungen verhindern und den Einfluss von Störungen auf das Ionentriebwerk und eine Regelungsvorrichtung des Ionentriebwerks reduzieren.

Ein unvermeidbarer und ungewollter Energieeintrag in die Leistungsversorgungseinheit 19 wird durch die plasmaenergetischen Schutzeinrichtungen kontrolliert und nicht destruktiv abgeleitet. Hierfür ist eine Energiekompensationseinheit 60 in Form eines strom- und spannungspulsformenden Netzwerks vorgesehen, das z.B. aus Hochspannungsdioden und Suppressordioden (wie z.B. Transzorbdioden) und/oder weiteren passiven Bauteilen besteht und die einen Großteil der Energie absorbiert. Eine Anpassungseinheit 70 mit zwei Spulen (siehe Fig. 9) sorgt für einen definierten Stromfluss, indem eine galvanische Trennung zwischen den Spulen erfolgt, um sog. Common-Mode-Störungen zu unterdrücken.

Fig. 8 zeigt eine detaillierte Darstellung eines Beispiels einer Energiekompensationseinheit 60 mit zwei Zweigen 61, 62. Jeder Zweig 61,62 enthält eine Hochspannungsdiode 62, 66 und eine Suppressordiode 63, 67. Die erste Hochspannungsdiode 62 und die erste Suppressordiode 63 sind in dem ersten Zweig 61 in Reihe und gegenläufig zueinander geschaltet. Die zweite Hochspannungsdiode 66 und die zweite Suppressordiode 67 sind in dem zweiten Zweig 65 in Reihe und gegenläufig zueinander geschaltet. Dabei sind die beiden Zweige 61, 65 auch gegenläufig zueinander geschaltet, d.h. dass die erste Hochspannungsdiode 62 und die zweite Hochspannungsdiode 66 gegenläufig zueinander geschaltet sind und dass die erste Suppressordiode 63 und die zweite Suppressordiode 67 auch gegenläufig zueinander geschaltet sind. Auf diese Weise stellt die Energiekompensationseinheit 60 eine kapazitätsarme bipolare Spannungsbegrenzung dar.

Fig. 9 zeigt eine detaillierte Darstellung einer Anpassungseinheit 70 dar. Die Anpassungseinheit 70 weist eine erste Schnittstelle 77 und eine zweite Schnittstellt 78 auf. Die erste Schnittstelle 77 dient dazu, eine elektrische Verbindung zu der Energiekompensationseinheit 60 oder dem Schwingkreis 30 des Ionentriebwerks herzustellen bzw. allgemein dazu, Energie an die Triebwerkseinheit des Ionentriebwerks abzugeben. Die zweite Schnittstelle 78 erhält Energie von der Leistungsversorgungseinheit.

An der ersten Schnittstelle 77 ist eine erste Spule 71 angeordnet, an der zweiten Schnittstelle 78 ist eine zweite Spule 73 angeordnet, die in diesem Beispiel über einen Kondensator 74 mit Masse verbunden ist (der Kondensator 74 kann aber auch mit einer anderen Komponente bzw. auf einem anderen Potential als Masse verbunden sein). Zwischen den Spulen 71, 73 ist ein Kern 72 angeordnet. Die Spulen 71, 73 und der Kern 72 bilden einen Transformator. Damit sind die erste Schnittstelle 77 und die zweite Schnittstelle 78 galvanisch getrennt. Wechselstrom wird über die Spulen 71, 73 übertragen.

Fig. 10 zeigt eine detaillierte Darstellung der Störungsunterdrückungseinheit 80, welche schon in Fig. 7 gezeigt wurde. Die Störungsunterdrückungseinheit 80 enthält ein Induktivität 82 sowie den Kondensator 15 des Schwingkreises 30 der Triebwerkseinheit des Ionentriebwerks. Die Induktivität 82 und der Kondensator 15 bilden einen L-C-Spannungsteiler. Der Abgriff der Energie für die Spule 14 des Ionentriebwerks ist zwischen der Induktivität 82 und dem Kondensator 15.

Es ist zu verstehen, dass die plasmaenergetischen Schutzeinrichtungen 60, 70, 80 au den Fig. 8 bis 10 jeweils für sich genommen einzeln oder in Kombination mit einer der anderen beiden oder allen beiden anderen plasmaenergetischen Schutzeinrichtungen in einem Ionentriebwerk verwendet werden können. Ebenso können eine oder mehrere (beliebige zwei oder alle drei) der plasmaenergetischen Schutzeinrichtungen 60, 70, 80 mit der mit Bezug zu den Fig. 2 bis 5 beschriebenen Regelungsvorrichtung verwendet werden.

### Bezugszeichenliste

- 10: Ionentriebwerk
- 11: Treibstoffleitung
- 12: Gehäuse
- 13: Anschluss
- 14: Spule
- 15: Kapazität
- 16: Gitteranordnung
- 17: Triebwerkseinheit
- 18: Neutralisiereinheit
- 19: Leistungsversorgungseinheit
- 20: Treibstoff
- 22: Kathode
- 24: elektrisches Feld
- 26: beschleunigte Ionen
- 30: Schwingkreis
- 31: Leitung
- 32: Schaltwerk
- 34: Spannungsversorgung
- 36: Last, Plasma
- 50: Frequenzgenerator
- 60: Energiekompensationseinheit
- 61: erster Zweig
- 62: erste Hochspannungsdiode
- 63: erste Suppressordiode
- 65: zweiter Zweig
- 66: zweite Hochspannungsdiode
- 67: zweite Suppressordiode
- 70: Anpassungseinheit
- 71: erste Spule
- 72: Kern
- 73: zweite Spule
- 74: Kapazität
- 77: erste Schnittstelle
- 78: zweite Schnittstelle
- 80: Störungsunterdrückungseinheit
- 82: Induktivität
- 100: Regelungsvorrichtung
- 110: Erfassungseinheit
- 115: Tiefpass
- 120: Recheneinheit
- 125: Verzögerungsglied
- 130: Signalverlauf
- 132: Grundwelle
- 134: Oberwelle
- 136: Nulllinie
- 140: erster Signalverlauf, Schaltsignal
- 150: zweiter Signalverlauf, Arbeitssignal

## Patentansprüche

1. Regelungsvorrichtung (100) für einen Frequenzgenerator (50), die Regelungsvorrichtung (100) aufweisend:
eine Erfassungseinheit (110); und
eine Recheneinheit (120);
wobei die Erfassungseinheit (110) ausgeführt ist, einen Spannungsverlauf und einen Stromverlauf des einen Frequenzgenerators (50) zu erfassen und an die Recheneinheit (120) zu übertragen;
wobei die Recheneinheit (120) ausgeführt ist, einen zeitlichen Versatz (Δt₁, Δt₂) zwischen einer Flanke des Stromverlaufs und einer zugehörigen Flanke des Spannungsverlaufs zu ermitteln;
wobei die Recheneinheit (120) ausgeführt ist, ein Schaltsignal zum Ausgeben des Spannungsverlaufs zu erzeugen und zu verändern, um den zeitlichen Versatz zwischen einer Flanke des Stromverlaufs und einer zugehörigen Flanke des Spannungsverlaufs zu reduzieren;
wobei die Erfassungseinheit (110) ausgeführt ist, einen Zeitpunkt eines Nulldurchgangs des Spannungsverlaufs und einen Zeitpunkt eines Nulldurchgangs des Stromverlaufs zu erkennen;
**dadurch gekennzeichnet, dass**
die Erfassungseinheit (110) ausgeführt ist, nach dem Erkennen eines Nulldurchgangs des Spannungsverlaufs und/ oder eines Nulldurchgangs des Stromverlaufs, das erneute Erkennen eines Nulldurchgangs des Spannungsverlaufs und/oder eines Nulldurchgangs des Stromverlaufs für eine Sperrzeit auszusetzen und das erneute Erkennen eines Nulldurchgangs des Spannungsverlaufs und/oder eines Nulldurchgangs des Stromverlaufs erst nach Ablauf der Sperrzeit zuzulassen;
die Erfassungseinheit (110) ausgeführt ist, das erneute Erkennen eines Nulldurchgangs des Spannungsverlaufs und/ oder eines Nulldurchgangs des Stromverlaufs nach Ablauf der Sperrzeit für die Dauer einer Erfassungszeit zuzulassen; und
die Erfassungszeit sich unmittelbar an die Sperrzeit anschließt, und eine Dauer hat, die dem Doppelten der Differenz zwischen der aktuellen Periodendauer des Spannungsverlaufs und/ oder des Stromverlaufs und dem Anteil der Sperrzeit an dieser aktuellen Periodendauer entspricht.

2. Regelungsvorrichtung (100) nach Anspruch 1,
wobei die Erfassungseinheit (110) ausgeführt ist, einen während der Erfassungszeit erkannten Nulldurchgang an die Recheneinheit (120) zu übertragen;
wobei die Recheneinheit (120) ausgeführt ist, basierend auf dem während der Erfassungszeit erkannten Nulldurchgang die aktuelle Periodendauer des erfassten Strom- und/oder Spannungsverlaufs neu zu ermitteln;
wobei die Recheneinheit (120) ausgeführt ist, basierend auf der neu ermittelten Periodendauer des erfassten Strom- und/oder Spannungsverlaufs die Sperrzeit und die Erfassungszeit neu zu definieren.

3. Regelungsvorrichtung (100) nach Anspruch 2,
wobei sich die neu definierte Sperrzeit unmittelbar an den während der Erfassungszeit erkannten Nulldurchgang anschließt.

4. Regelungsvorrichtung (100) nach einem der voranstehenden Ansprüche,
wobei die Erfassungseinheit (110) einen Tiefpass (115) aufweist;
wobei der Tiefpass (115) ausgeführt ist, Signalanteile des erfassten Strom- und/oder Spannungsverlaufs, die einen vorgebbaren Frequenzschwellwert überschreiten, zu filtern.

5. Regelungsvorrichtung (100) nach Anspruch 4,
wobei die Erfassungseinheit (110) ausgeführt ist, den Zeitpunkt eines Nulldurchgangs des Spannungsverlaufs und/oder den Zeitpunkt eines Nulldurchgangs des Stromverlaufs zu erkennen, nachdem der erfasste Strom- und/oder Spannungsverlauf von dem Tiefpass (115) gefiltert wurde.

6. Regelungsvorrichtung (100) nach einem der voranstehenden Ansprüche,
wobei die Regelungsvorrichtung (100) ein Verzögerungsglied (125) aufweist;
wobei das Verzögerungsglied (125) ausgestaltet ist, dem Zeitpunkt eines erfassten Nulldurchgangs des Spannungsverlaufs und/oder eines erfassten Nulldurchgangs des Stromverlaufs eine Verzögerung hinzuzufügen, bevor die Recheneinheit (120) den zeitlichen Versatz (Δt₁, Δt₂) zwischen einer Flanke des Stromverlaufs und einer zugehörigen Flanke des Spannungsverlaufs ermittelt.

7. Regelungsvorrichtung (100) nach Anspruch 6,
wobei die Verzögerung ein Phasenversatz ist, der sich auf die Periodendauer des erfassten Strom- und/oder Spannungsverlaufs bezieht.

8. Ionentriebwerk (10), aufweisend:
einen Frequenzgenerator (50) zum Abgeben von elektrischer Energie mit einer vorgebbaren Frequenz, um ein elektrisches Feld (24) zu erzeugen; und
eine Regelungsvorrichtung (100) nach einem der voranstehenden Ansprüche;
wobei die Regelungsvorrichtung (100) mit dem Frequenzgenerator (50) gekoppelt ist, um den Frequenzgenerator bei einer vorgegebenen Frequenz zu betreiben, so dass ein Treibstoff (20) in dem elektrischen Feld (24) ionisiert wird.

9. Ionentriebwerk (10) nach Anspruch 8,
wobei der Frequenzgenerator (50) einen Schwingkreis (30) aufweist; und
wobei der Schwingkreis ein R-L-C-Schwingkreis ist.

10. Ionentriebwerk (10) nach Anspruch 9,
wobei der Frequenzgenerator (50) ein Halbleiter-Schaltwerk (32) aufweist, welches mit dem Schwingkreis (30) gekoppelt ist und ausgeführt ist, den Schwingkreis (30) gemäß dem Schaltsignal der Regelungsvorrichtung (100) anzusteuern.

11. Ionentriebwerk (10) nach einem der Ansprüche 8 bis 10, ferner aufweisend:
eine Triebwerkseinheit (17); und
eine Leistungsversorgungseinheit (19) mit einem Schaltwerk (32);
wobei das Schaltwerk (32) eine Energiekompensationseinheit (60) aufweist;
wobei die Energiekompensationseinheit (60) ausgangsseitig in dem Schaltwerk (32) angeordnet ist und ausgestaltet ist, einen Leistungsüberschlag von der Triebwerkseinheit (17) auf die Leistungsversorgungseinheit (19) mindestens teilweise aufzunehmen;
wobei die Energiekompensationseinheit (60) als kapazitätsarme bipolare Spannungsbegrenzung ausgestaltet ist.

12. Ionentriebwerk (10) nach Anspruch 11,
wobei die Energiekompensationseinheit (60) einen ersten Zweig (61) und einen zweiten Zweig (65) aufweist;
wobei der erste Zweig (61) eine erste Hochspannungsdiode (62) und eine dazu in Reihe und gegenläufig geschaltete erste Suppressordiode (63) aufweist;
wobei der zweite Zweig (65) eine zweite Hochspannungsdiode (66) und eine dazu in Reihe und gegenläufig geschaltete zweite Suppressordiode (67) aufweist;
wobei die erste Hochspannungsdiode (62) gegenläufig zu der zweiten Hochspannungsdiode (66) geschaltet ist;
wobei die erste Suppressordiode (63) gegenläufig zu der zweiten Suppressordiode (67) geschaltet ist.

13. Ionentriebwerk (10) nach einem der Ansprüche 8 bis 10, ferner aufweisend:
eine Triebwerkseinheit (17); und
eine Leistungsversorgungseinheit (19) mit einem Schaltwerk (32);
wobei das Schaltwerk (32) eine Anpassungseinheit (70) aufweist;
wobei die Anpassungseinheit (70) eine erste Schnittstelle (77) und eine zweite Schnittstelle (78) aufweist;
wobei die Anpassungseinheit (80) ausgeführt ist, über die zweite Schnittstelle (78) elektrische Energie von elektronischen Komponenten der Leistungsversorgungseinheit (19) aufzunehmen und über die erste Schnittstelle (77) elektrische Energie zu der Triebwerkseinheit (17) abzugeben;
wobei die erste Schnittstelle (77) von der zweiten Schnittstelle (78) galvanisch getrennt ist.

14. Ionentriebwerk (10) nach einem der Ansprüche 8 bis 10, ferner aufweisend:
eine Triebwerkseinheit (17);
eine Leistungsversorgungseinheit (19); und
eine Störungsunterdrückungseinheit (80);
wobei die Störungsunterdrückungseinheit (80) an einer Schnittstelle zwischen der Leistungsversorgungseinheit (19) und der Triebwerkseinheit (17) angeordnet ist und ausgestaltet ist, Störungen in einer elektrischen Verbindung (31) zwischen der Leistungsversorgungseinheit (19) und der Triebwerkseinheit (17) aufzunehmen und zu unterdrücken;
wobei die Störungsunterdrückungseinheit (80) eine als Spannungsteiler miteinander verschaltete Induktivität (82) und eine Kapazität (15) aufweist;
wobei die elektrische Verbindung (31) die Triebwerkseinheit (17) mit einem Knoten zwischen der Induktivität (82) und der Kapazität (15) verbindet.

## Claims

1. Control device (100) for a frequency generator (50), the control device (100) having:
a recording unit (110); and
a computing unit (120);
wherein the recording unit (110) is designed to record a voltage profile and a current profile of the one frequency generator (50) and to transmit these to the computing unit (120);
wherein the computing unit (120) is designed to determine a temporal offset (Δt₁, Δt₂) between an edge of the current profile and an associated edge of the voltage profile;
wherein the computing unit (120) is designed to generate and change a switching signal for outputting the voltage profile in order to reduce the temporal offset between an edge of the current profile and an associated edge of the voltage profile;
wherein the recording unit (110) is designed to detect a time of a zero crossing of the voltage profile and a time of a zero crossing of the current profile;
**characterized in that**,
after detecting a zero crossing of the voltage profile and/or a zero crossing of the current profile, the recording unit (110) is designed to suspend further detection of a zero crossing of the voltage profile and/or of a zero crossing of the current profile for a blocking time, and to allow further detection of a zero crossing of the voltage profile and/or of a zero crossing of the current profile only after the blocking time has elapsed;
the recording unit (110) is designed to allow further detection of a zero crossing of the voltage profile and/or a zero crossing of the current profile after the blocking time has elapsed for the duration of a recording time; and
the recording time directly follows the blocking time and has a duration that corresponds to double the difference between the present period duration of the voltage profile and/or the current profile and the proportion of the blocking time in this present period duration.

2. Control device (100) according to Claim 1,
wherein the recording unit (110) is designed to transmit a zero crossing detected during the recording time to the computing unit (120);
wherein the computing unit (120) is designed to newly determine the present period duration of the recorded current and/or voltage profile on the basis of the zero crossing detected during the recording time;
wherein the computing unit (120) is designed to newly define the blocking time and the recording time on the basis of the newly determined period duration of the recorded current and/or voltage profile.

3. Control device (100) according to Claim 2,
wherein the newly defined blocking time directly follows the zero crossing detected during the recording time.

4. Control device (100) according to one of the preceding claims,
wherein the recording unit (110) has a low-pass filter (115);
wherein the low-pass filter (115) is designed to filter signal components of the recorded current and/or voltage profile that exceed a predefinable frequency threshold value.

5. Control device (100) according to Claim 4,
wherein the recording unit (110) is designed to detect the time of a zero crossing of the voltage profile and/or the time of a zero crossing of the current profile after the recorded current and/or voltage profile has been filtered by the low-pass filter (115).

6. Control device (100) according to one of the preceding claims,
wherein the control device (100) has a delay element (125) ;
wherein the delay element (125) is configured to add a delay to the time of a recorded zero crossing of the voltage profile and/or of a recorded zero crossing of the current profile before the computing unit (120) determines the temporal offset (Δt₁, Δt₂) between an edge of the current profile and an associated edge of the voltage profile.

7. Control device (100) according to Claim 6,
wherein the delay is a phase offset that relates to the period duration of the recorded current and/or voltage profile.

8. Ion thruster (10), having:
a frequency generator (50) for outputting electrical energy with a predefinable frequency in order to generate an electric field (24); and
a control device (100) according to one of the preceding claims;
wherein the control device (100) is coupled to the frequency generator (50) in order to operate the frequency generator at a predefined frequency such that a propellant (20) is ionized in the electric field (24).

9. Ion thruster (10) according to Claim 8,
wherein the frequency generator (50) has a resonant circuit (30); and
wherein the resonant circuit is an RLC resonant circuit.

10. Ion thruster (10) according to Claim 9,
wherein the frequency generator (50) has a semiconductor switching mechanism (32) that is coupled to the resonant circuit (30) and is designed to actuate the resonant circuit (30) in accordance with the switching signal of the control device (100).

11. Ion thruster (10) according to one of Claims 8 to 10, also having:
a thruster unit (17); and
a power supply unit (19) comprising a switching mechanism (32) ;
wherein the switching mechanism (32) has an energy compensation unit (60);
wherein the energy compensation unit (60) is arranged on the output side in the switching mechanism (32) and is configured to at least partially absorb a power flashover from the thruster unit (17) to the power supply unit (19);
wherein the energy compensation unit (60) is in the form of a low-capacitance bipolar voltage limiting means.

12. Ion thruster (10) according to Claim 11,
wherein the energy compensation unit (60) has a first branch (61) and a second branch (65);
wherein the first branch (61) has a first high-voltage diode (62) and a first suppressor diode (63) connected in series therewith and in opposition thereto;
wherein the second branch (65) has a second high-voltage diode (66) and a second suppressor diode (67) connected in series therewith and in opposition thereto;
wherein the first high-voltage diode (62) is connected in opposition to the second high-voltage diode (66);
wherein the first suppressor diode (63) is connected in opposition to the second suppressor diode (67).

13. Ion thruster (10) according to one of Claims 8 to 10, also having:
a thruster unit (17); and
a power supply unit (19) comprising a switching mechanism (32) ;
wherein the switching mechanism (32) has an adaptation unit (70);
wherein the adaptation unit (70) has a first interface (77) and a second interface (78);
wherein the adaptation unit (80) is designed to receive electrical energy from electronic components of the power supply unit (19) via the second interface (78) and to output electrical energy to the thruster unit (17) via the first interface (77);
wherein the first interface (77) is galvanically isolated from the second interface (78).

14. Ion thruster (10) according to one of Claims 8 to 10, also having:
a thruster unit (17);
a power supply unit (19); and
an interference suppression unit (80);
wherein the interference suppression unit (80) is arranged at an interface between the power supply unit (19) and the thruster unit (17), and is configured to receive and suppress interference in an electrical connection (31) between the power supply unit (19) and the thruster unit (17);
wherein the interference suppression unit (80) has an inductor (82) interconnected in the form of a voltage divider and a capacitor (15);
wherein the electrical connection (31) connects the thruster unit (17) to a node between the inductor (82) and the capacitor (15).

## Revendications

1. Dispositif de régulation (100) pour un générateur de fréquences (50), le dispositif de régulation (100) comprenant :
une unité d'acquisition (110) ; et
une unité de traitement (120) ;
dans lequel l'unité d'acquisition (110) est conçue pour acquérir une courbe de tension et une courbe de courant du générateur de fréquences (50) et pour les transmettre à l'unité de traitement (120) ;
dans lequel l'unité de traitement (120) est conçue pour déterminer un décalage temporel (Δt₁, Δt₂) entre un front de la courbe de courant et un front associé de la courbe de tension ;
dans lequel l'unité de traitement (120) est conçue pour générer et modifier un signal de commutation pour délivrer en sortie la courbe de tension afin de réduire le décalage temporel entre un front de la courbe de courant et un front associé de la courbe de tension ;
dans lequel l'unité d'acquisition (110) est conçue pour détecter un instant d'un passage par zéro de la courbe de tension et un instant d'un passage par zéro de la courbe de courant ;
**caractérisé en ce que**
l'unité d'acquisition (110) est conçue pour, après la détection d'un passage par zéro de la courbe de tension et/ou d'un passage par zéro de la courbe de courant, suspendre détection à nouveau d'un passage par zéro de la courbe de tension et/ou d'un passage par zéro de la courbe de courant pendant une durée de blocage et ne permettre la détection à nouveau d'un passage par zéro de la courbe de tension et/ou d'un passage par zéro de la courbe de courant qu'après l'expiration de la durée de blocage ;
l'unité d'acquisition (110) est conçue pour permettre la détection à nouveau d'un passage par zéro de la courbe de tension et/ou d'un passage par zéro de la courbe de courant après l'expiration de la durée de blocage pendant la durée d'un temps d'acquisition ; et
le temps d'acquisition suit immédiatement la durée de blocage, et a une durée qui correspond au double de la différence entre la période actuelle de la courbe de tension et/ou de la courbe de courant et la part de la durée de blocage dans cette période actuelle.

2. Dispositif de régulation (100) selon la revendication 1,
dans lequel l'unité d'acquisition (110) est conçue pour transmettre à l'unité de traitement (120) le passage par zéro détecté pendant le temps d'acquisition ;
dans lequel l'unité de traitement (120) est conçue pour déterminer la période actuelle des courbes de courant et/ou de tension acquises sur la base du passage par zéro détecté pendant le temps d'acquisition ;
dans lequel l'unité de traitement (120) est conçue pour redéfinir la durée de blocage et le temps d'acquisition sur la base de la période nouvellement déterminée des courbes de courant et/ou de tension.

3. Dispositif de régulation (100) selon la revendication 2,
dans lequel la durée de blocage nouvellement définie suit immédiatement le passage par zéro détecté pendant le temps d'acquisition.

4. Dispositif de régulation (100) selon l'une des revendications précédentes,
dans lequel l'unité d'acquisition (110) comprend un filtre passe-bas (115) ;
dans lequel le filtre passe-bas (115) est conçu pour filtrer les composantes de signal des courbes de courant et/ou de tension acquises qui dépassent un seuil de fréquence prédéfinissable.

5. Dispositif de régulation (100) selon la revendication 4,
dans lequel l'unité d'acquisition (110) est conçue pour détecter l'instant d'un passage par zéro de la courbe de tension et/ou l'instant d'un passage par zéro de la courbe de courant, après que la courbe de courant et/ou de tension acquise a été filtrée par le filtre passe-bas (115).

6. Dispositif de régulation (100) selon l'une des revendications précédentes,
dans lequel le dispositif de régulation (100) comprend un élément de retard (125) ;
dans lequel l'élément de retard (125) est conçu pour ajouter un retard à l'instant d'un passage par zéro détecté de la courbe de tension et/ou d'un passage par zéro détecté de la courbe de courant, avant que l'unité de traitement (120) détermine le décalage temporel (Δt₁, Δt₂) entre un front de la courbe de courant et un front associé de la courbe de tension.

7. Dispositif de régulation (100) selon la revendication 6,
dans lequel le retard est un déphasage qui se rapporte à la période des courbes de courant et/ou de tension acquises.

8. Moteur ionique (10), comprenant :
un générateur de fréquences (50) pour délivrer de l'énergie électrique à une fréquence prédéfinissable afin de générer un champ électrique (24) ; et
un dispositif de régulation (100) selon l'une des revendications précédentes ;
dans lequel le dispositif de régulation (100) est couplé au générateur de fréquences (50) pour faire fonctionner le générateur de fréquences à une fréquence prédéfinie, de telle sorte qu'un carburant (20) soit ionisé dans le champ électrique (24).

9. Moteur ionique (10) selon la revendication 8,
dans lequel le générateur de fréquences (50) comprend un circuit oscillant (30) ; et
dans lequel le circuit oscillant est un circuit oscillant R-L-C.

10. Moteur ionique (10) selon la revendication 9,
dans lequel le générateur de fréquences (50) comprend un circuit de commutation à semi-conducteurs (32) qui est couplé au circuit oscillant (30) et est conçu pour commander le circuit oscillant (30) conformément au signal de commutation du dispositif de régulation (100).

11. Moteur ionique (10) selon l'une des revendications 8 à 10, comprenant en outre :
une unité de propulsion (17) ; et
une unité d'alimentation en puissance (19) avec un circuit de commutation (32) ;
dans lequel le circuit de commutation (32) comprend une unité de compensation d'énergie (60) ;
dans lequel l'unité de compensation d'énergie (60) est agencée côté sortie dans le circuit de commutation (32) et est conçue pour au moins partiellement absorber une surtension de puissance de l'unité de propulsion (17) vers l'unité d'alimentation en puissance (19) ;
dans lequel l'unité de compensation d'énergie (60) est conçue sous forme de limitation de tension bipolaire à faible capacité.

12. Moteur ionique (10) selon la revendication 11, dans lequel l'unité de compensation d'énergie (60) comprend une première branche (61) et une deuxième branche (65) ;
dans lequel la première branche (61) comprend une première diode haute tension (62) et une première diode de suppression (63) montée en série et en opposition à celle-ci ;
dans lequel la deuxième branche (65) comprend une deuxième diode haute tension (66) et une deuxième diode de suppression (67) montée en série et en opposition à celle-ci ;
dans lequel la première diode haute tension (62) est montée en opposition à la deuxième diode haute tension (66) ;
dans lequel la première diode de suppression (63) est montée en opposition à la deuxième diode de suppression (67).

13. Moteur ionique (10) selon l'une des revendications 8 à 10, comprenant en outre :
une unité de propulsion (17) ; et
une unité d'alimentation en puissance (19) avec un circuit de commutation (32) ;
dans lequel le circuit de commutation (32) comprend une unité d'adaptation (70) ;
dans lequel l'unité d'adaptation (70) comprend une première interface (77) et une deuxième interface (78) ;
dans lequel l'unité d'adaptation (80) est conçue pour absorber, par l'intermédiaire de la deuxième interface (78), l'énergie électrique provenant des composants électroniques de l'unité d'alimentation en puissance (19) et pour délivrer, par l'intermédiaire de la première interface (77), l'énergie électrique à l'unité de propulsion (17) ;
dans lequel la première interface (77) est galvaniquement isolée de la deuxième interface (78).

14. Moteur ionique (10) selon l'une des revendications 8 à 10, comprenant en outre :
une unité de propulsion (17) ;
une unité d'alimentation en puissance (19) ; et
une unité de suppression de perturbations (80) ;
dans lequel l'unité de suppression de perturbations (80) est agencée à une interface entre l'unité d'alimentation en puissance (19) et l'unité de propulsion (17) et est conçue pour enregistrer et supprimer les perturbations dans une connexion électrique (31) entre l'unité d'alimentation en puissance (19) et l'unité de propulsion (17) ;
dans lequel l'unité de suppression de perturbations (80) comprend une inductance (82) et une capacité (15) connectées l'une à l'autre en tant que diviseur de tension ;
dans lequel la connexion électrique (31) relie l'unité de propulsion (17) à un nœud situé entre l'inductance (82) et la capacité (15).
